# EUROPEAN PATENT APPLICATION

(11) **EP 0 572 232 A2**
(43) Date of publication of application: **01.12.1993**
(21) Application number: 93304072.7
(22) Date of filing: 26.05.1993
(51) Int. Cl.: H05K 3/46

(54) **A multilayer printed circuit board and method for manufacturing same**

(30) Priority: 29.05.1992 JP 164342/92
(71) Applicant: Nippon CMK Corp., Iruma-Gun Saitama (JP)
(72) Inventor: Matsumoto, Masuo, Iruma-gun, Saitama (JP); Birukawa, Fusao, Iruma-gun, Saitama (JP); Takahashi, Takazo, Iruma-gun, Saitama (JP); Shirai, Junzaburo, Iruma-gun, Saitama (JP); Kojima, Mikiya, Iruma-gun, Saitama (JP)
(74) Representative: Boydell, John Christopher

(57) **Abstract**

A multilayer printed circuit board in which connection holes formed in an inner substrate (1) are filled with conductive paste (22) and the conductive paste is sealed by means of a plated layer (23). After lamination of the inner substrate (1) and outer substrates (2, 3), these connection holes are filled with the conductive paste. Then, the conductive paste is covered and sealed with the plated layer (23). Thus, lands and circuit may be formed in the plated layer (23) corresponding to the connection holes by means of etching.

## Description

This invention relates to a multilayer printed circuit board and to a method of manufacturing same.

In general, a multilayer printed circuit board with four, six or eight conductive layers has a higher circuit density than the conventional double-sided printed circuit board. In the case of conventional multilayer printed circuit boards, in order to form the necessary circuit and electrical connections between each of the substrates, connection holes such as blind-via-holes or through-holes are used. In the connection holes, plated layers of conductive materials such as copper are formed. However, instead of the above-described construction of the conventional multilayer printed circuit board, a problem arises in the reliability for electrical connections.

Figure 13 of the accompanying drawings is an illustration showing the multilayer printed circuit board developed by the inventor of this invention for improving reliability. Outer substrates 110 are laminated with adhesive sheets 120 on the front and back sides of an inner substrate 100. On both sides of an inner substrate, a circuit 101 and lands 102 are formed. On the outer surfaces of each outer substrate 100, a circuit 111 and lands 112 are formed. Blind-via-holes 121, through-holes 122, 123 and interstitial-via-holes 124 form the connection holes. These connection holes connect between the land 102 of inner substrate 100 and the land 112 of outer substrate 110, or connect between the lands 102 on both surfaces of inner substrate 100.

In order to connect these lands electrically, the blind-via-hole 121, through-holes 122, 123 and interstitial-via-hole 124 are filled with conductive paste 130. The diameter of these connection holes of outer substrates 110 are larger than those of the connection holes of the inner substrate 100, so that wide areas are exposed on the lands 102 where the conductive paste 130 has wide contact areas to achieve improved reliability in the electrical connections. In Figure 13, reference numeral 140 shows a protective coating which covers the exposed area of conductive paste 130. Reference numeral 150 shows solder resist for covering outer substrates 110.

In the aforementioned conventional multilayer printed circuit board, however, connection-holes of blind-via-hole 121, through-holes 122, 123 and interstitial-via-hole 124 are limited in use to electrical connections between lands. These areas for connection holes cannot be used for circuit or other usage. Therefore, the connection holes for connecting between lands become an obstacle in the manufacture of high density printed circuit board.

The present invention seeks to provide a multilayer printed circuit board and a manufacturing method which overcome the limitation to high density printed circuit board.

According to a first aspect of this invention, there is provided a multilayer printed circuit board comprising at least two laminated printed circuit boards in which connection holes are formed. The connection holes are filled with conductive paste and the conductive paste is sealed with plated layer. In this invention, the diameter of the connection holes in one of the printed circuit boards can be made larger than that of the connection holes in the other printed circuit board.

According to a second aspect of this invention, there is provided a manufacturing method of a multilayer printed circuit board, said method comprising the steps of: laminating at least two printed circuit boards as the first substrate and the second substrate, forming connection hole penetrating both the first substrate and the second substrate and forming a connection hole penetrating not both the first substrate and the second substrate through these laminated substrates, filling the connection holes with conductive paste, and forming a plated layer on the conductive paste.

There is provided another manufacturing method of the multilayer printed circuit board comprising the steps of: forming a connection hole in the first substrate, filling the connection hole with conductive paste, sealing the conductive paste by a plated layer, forming a connection hole at least in one substrate as the second substrate, laminating the second substrate with the first substrate, filling the connection hole in the second substrate with conductive paste and filling the connection hole corresponding to both the first substrate and the second substrate with the conductive paste, and sealing the conductive paste by a plated layer.

There is provided still another manufacturing method of the multilayer printed circuit board comprising the steps of: forming a connection hole in the first substrate, filling the connection hole with conductive paste, sealing the conductive paste by a plated layer, laminating at least one substrate as the second substrate with the first substrate, forming a connection hole in the second substrate, filling the connection hole in the second substrate with conductive paste and filling the connection hole corresponding to both the first substrate and the second substrate with conductive paste, and sealing the conductive paste by a plated layer.

According to the present invention, connection holes are filled with conductive paste which connect electrically between lands in plural number of printed circuit boards or between lands in both front and back sides of a printed circuit board, and the conductive paste is covered and sealed with a plated layer, so that connection reliability is improved.

Furthermore, by means of proper processing onto the plated layer, the plated layer to seal the conductive paste can be not only used for a circuit but also used for lands to mount electric components. Therefore, the area of the connection hole can be effectively used for the circuit or for the lands so that a high density printed circuit board can be produced.

The aforementioned manufacturing method offers reliable multilayer printed circuit board without fail, because connection holes are formed in plural number of substrates which are to be laminated, and the connection holes are filled with conductive paste, and then the conductive paste is sealed with a plated layer.

In order that the invention may be better understood, several embodiments thereof will now be described by way of example only and with reference to the accompanying drawings in which:-
Figure 1 is a flow chart of the manufacturing processes of a first embodiment of this invention;
Figure 2 is a sectional view of the inner substrate;
Figure 3 is a sectional view of the inner substrate in a manufacturing process according to the invention;
Figure 4 is a sectional view of the inner substrate in another manufacturing process;
Figure 5 is a sectional view of the inner substrate in still another manufacturing process;
Figure 6 is a sectional view of the inner substrate in still another manufacturing process;
Figure 7 is a sectional view of the inner substrate in still another manufacturing process;
Figure 8 is a sectional view of the inner and outer substrates before the lamination process;
Figure 9 is a sectional view of the inner and outer substrates after the lamination process;
Figure 10 is a sectional view of the process after the lamination process;
Figure 11 is a sectional view of another process after the lamination process;
Figure 12 is a sectional view of another embodiment of this invention; and
Figure 13 is a sectional view of a conventional multilayer printed circuit board as the prior art.

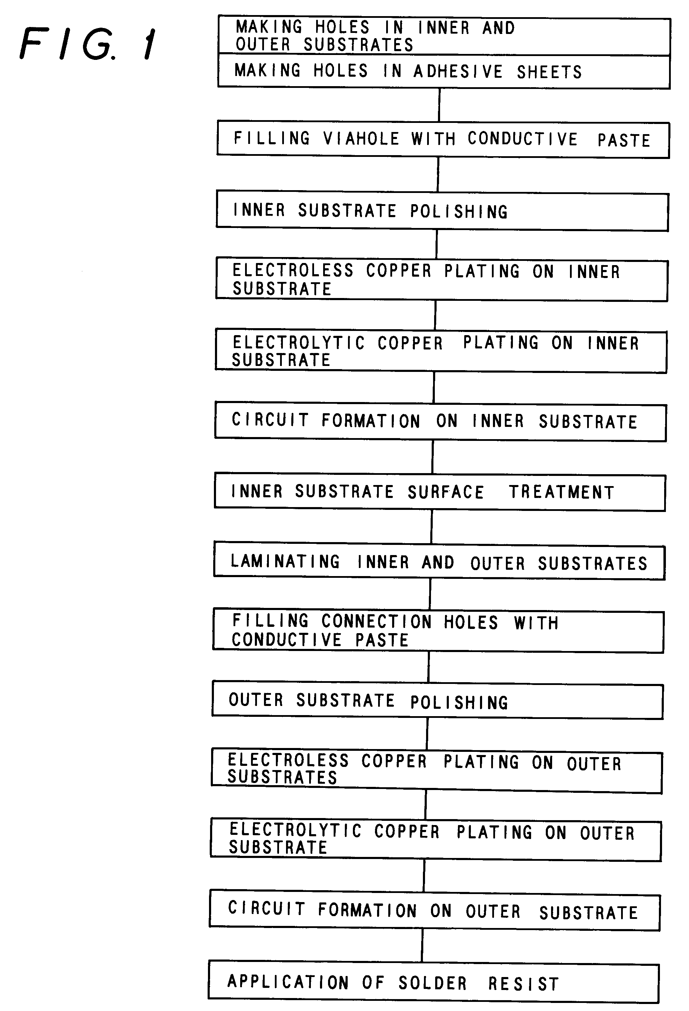

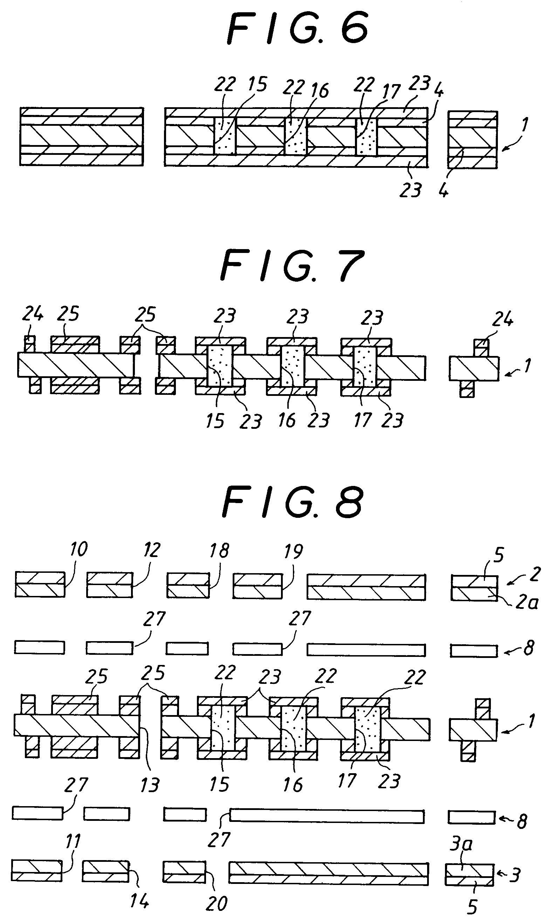

In the embodiment of Figure 1, an outer substrate 2 is laminated on the upper side of an inner substrate 1 and an outer substrate 3 is laminated on the lower side of the inner substrate 1. A circuit on the upper substrate 2 forms a first conductor, a circuit on the upper side of the inner substrate 1 forms a second conductor, a circuit on the lower side of the inner substrate 1 forms a third conductor, and a circuit on the lower outer substrate 3 forms a fourth conductor. Thus, the circuit board has a four-layered construction. The inner substrate 1 comprises an insulating layer 1a having copper layers 4 applied on both sides thereof. The outer upper and lower substrates 2, 3 comprise insulating layers 2a, 3a having copper layers 5 applied on one side of each of the insulating layers 2a and 3a. An adhesive sheet 8 is inserted between the inner substrate 1 and each outer substrate 2 and 3. For the adhesive sheet 8, a suitable adhesive material such as epoxy, polyimide or a sheet impregnated with these plastics is used (refer to Figure 8).

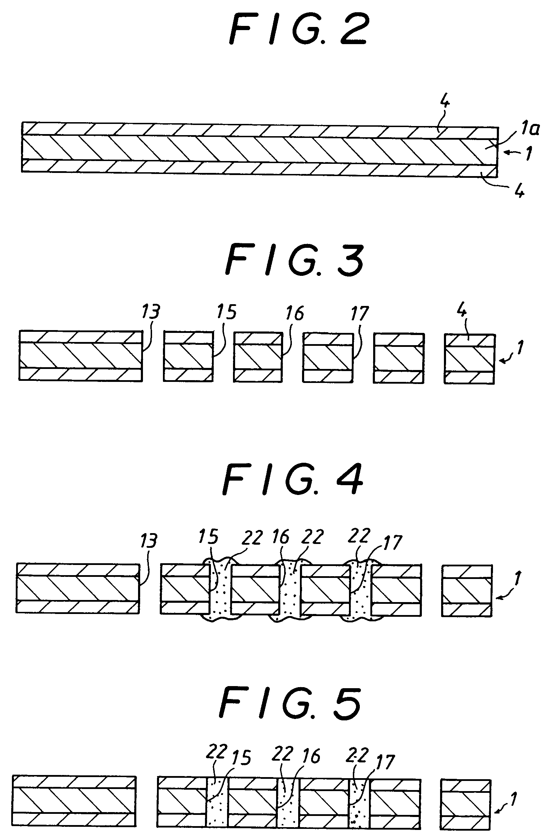

First of all, as shown in Figures 2 and 3, to make holes, the inner substrate 1 is drilled. At the same time the copper-layer laminated boards forming the outer substrates 2, 3 and adhesive sheet 8 are drilled. Drilling is the process for forming connection holes such as through-holes, blind-via-holes and interstitial-via-holes. These connection holes in each copper-layer laminated board are formed by means of punching or drilling so that the corresponding holes communicate with each other. As shown in Figure 8, the connection holes 10 and 11, which are formed in a corresponding position in an upper layer of the outer substrate 2 and in a lower layer of the outer substrate 3, are the blind-via-holes. Also, the connection holes 12, 13 and 14, which are formed in the inner substrate 1 and in the upper and the lower outer substrates 2 and 3, are the through-holes. The connection holes 15, 16 and 17, which are formed only in the inner substrate as shown in Figure 3, are the interstitial-via-holes. As shown in Figure 8, the connection holes 18, 19 and 20 are formed in the outer substrates 2 and 3 at a corresponding position to the connection holes 15 and 16.

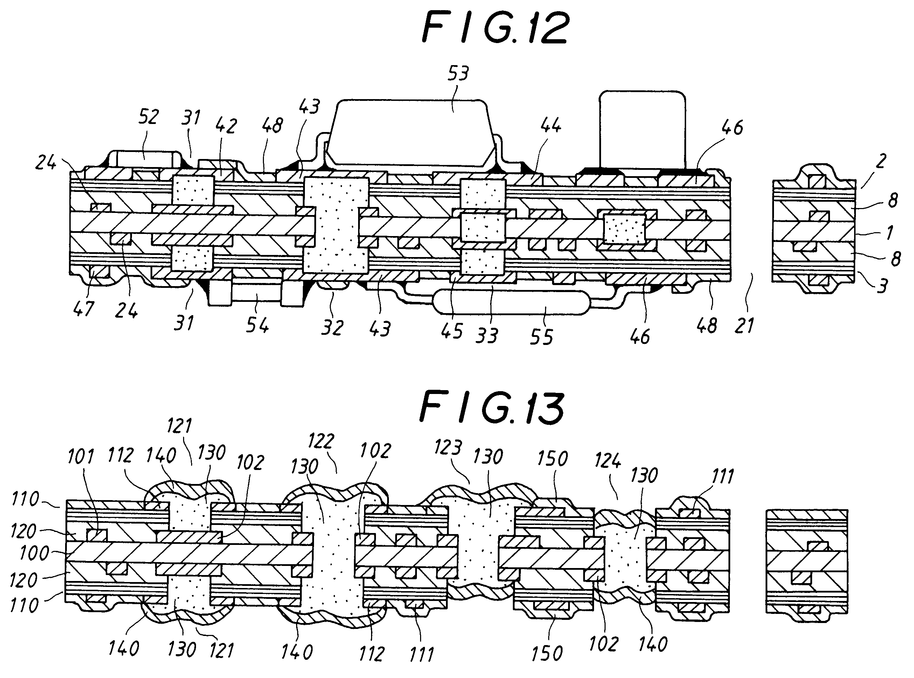

In Figure 11, reference numeral 21 is a non-through-hole which is formed through inner substrate 1, outer substrates 2, 3 and adhesive sheet 8, and the non-through-hole 21 is not used for electrical connection. Also, as shown in Figure 8, the connection holes 12 and 14 in the outer substrates 2, 3 have larger diameters than that of the connection hole 13 in the inner substrate, so that the land area of the through-hole in the inner substrate 1 is exposed wide. Therefore, the wide exposed land area can be supplied for conductive paste when conductive paste is filled into these through holes. Thus, the foregoing embodiment results in a highly reliable electrical connection.

Then, as shown in Figure 4, conducive paste is filled into the connection holes 15, 16 and 17. These connection holes 15, 16 and 17 are applied to the interstitial-via-holes of inner substrate 1. For the conductive paste, paste material such as copper paste or silver paste is properly selected and used. When filling the connection holes 15, 16 and 17 with the conductive paste, enough of the conductive paste is preferably used to fill in the connection holes and to overflow. After filling and curing, extruded conductive paste 22 is polished and ground flat and smooth as shown in Figure 5. After that, electroless copper plating is applied over the inner substrate 1, and then electro plating is applied. Thus, the conductive pastes in the connection holes 15, 16 and 17 are sealed by the plated layer 23 which is formed on both surfaces of the inner substrate 1. According to the present invention, the connection reliability of the interstitial-via-holes is improved by means of the foregoing seal on the conductive paste. Also, lamination of the outer substrates 2, 3 can be performed without failure because both surfaces of the inner substrate 1 are made flat by means of the plated layer 23. Moreover, in the foregoing embodiment, plated layer 23 on the outer surfaces of the conductive holes 15, 16 and 17 forms a conductive layer, so that the conductive layer can be used for the circuit or for the lands.

Figure 7 shows a state that circuits 24 and lands 25 are formed on both surfaces of an inner substrate 1. By means of photo-etching both plated layer 23 and copper layer 4, the circuits 24 and lands 25 are formed on both surfaces of the insulation layer 1a (shown in Figure 6). In the above photo-etching process, plated layer on the corresponding connection holes 15, 16 and 17 are not etched so that the un-etched and left-plated layer can cover and seal the conductive pastes which are filled in the connection holes 15, 16 and 17.

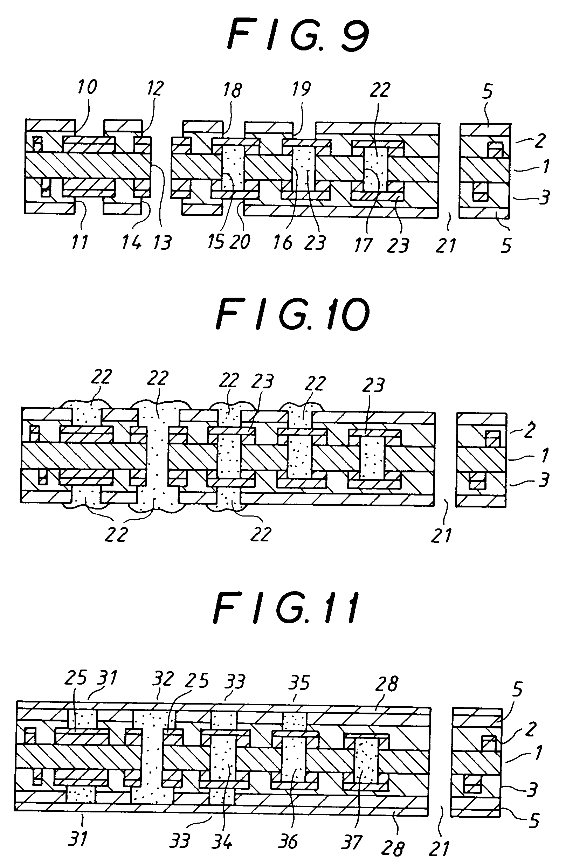

After the foregoing manufacturing steps of the circuits and lands, the surfaces of the circuits 24 and lands 25 on the front and back sides of the inner substrate 1 are black treated with such as melanism in order to increase adherence strength and the outer substrates 2, 3 are laminated on the inner substrate 1. In this laminating step, as shown in Figure 8, the inner substrate 1 and outer substrates 2, 3 as well as adhesive sheets 8 having holes 27 are aligned in their respective position so that the corresponding connection holes communicate with each other. By means of press-laminating or roll-laminating, the outer substrates 2 and 3 are adhered to the front and back side of the inner substrate 1, respectively, as shown in Figure 9.

Then, the conductive pastes are embedded in the conductive holes. That is as shown in Figures 9 and 10, connection holes 10, 11 of the outer substrates 2 and 3, connection holes 12, 14 of the outer substrates 2 and 3, connection hole 13 of the inner substrate 1 and connection holes 18, 19 and 20 of the outer substrates 2 and 3 are filled with conductive paste 22, where connection hole 12 and connection hole 13 are corresponding to each other. By means of the above filling process, the connection holes 10 and 11 are formed as blind-via-holes which connect the lands 25 of the inner substrate 1, and the connection holes 12, 13 and 14 are formed as through-holes which connect between inner substrate 1 and outer substrates 2, 3, and connection holes 18, 19 and 20 are formed as blind-via-holes which connect the interstitial-via-holes of inner substrate 1. After brush polishing to grind the conductive paste 22 in the connection holes flat, then, electroless copper plating and electro copper plating is performed over both upper and lower surfaces as shown in Figure 11. Then, plated layer 28 and copper layer 5 of the outer substrates 2, 3 are etched, thereby to form circuit and lands (not shown). In the above etching process, plated layer on the corresponding connection holes is not etched, and is left so that the un-etched plated layer can cover and seal the conductive paste in the connection holes.

In Figure 11, reference numeral 31 is a blind-via-hole which connects lands 25 of inner substrate 1, and reference numeral 32 is a through-hole which connects inner and outer substrates 1, 2 and 3. The conductive paste 22 is covered and sealed by the plating layer 28, so that connection reliability is improved. Therefore, these holes can be formed small in diameter, so that high density printed circuit board can be produced.

Reference numeral 33 is a blind-via-hole which is cascade connected to both upper and lower sides of the inner substrate 1 and forms the built-in blind-via-hole. However, the blind-via-hole 33 connects the lands of the inner and the outer substrates as the through-hole 32, the diameter of the blind-via-hole 33 can be smaller than that of through-hole 32 because high reliability is performed by means of seal plated layer on the conductive paste. Therefore, the blind-via-holes 33 of this invention are suited for producing printed circuit board having high density.

Reference numeral 35 is a blind-via-hole which is formed in the built-in form on an interstitial-via-hole 36. The blind-via-hole 35 works in the same way as the blind-via-hole 33. In the first embodiment of this invention the blind-via-holes 33 and 35 are connected with the interstitial-via-holes 34 and 36. Therefore, multiple lamination using the other additional outer substrates onto the aforementioned laminated outer substrates can be performed by using the processes of the foregoing embodiment. Thus, cascade connected and multiple structured blind-via-holes can be produced. Also, reference numeral 37 shows the interstitial-via-hole of the inner substrate 1.

Figure 12 is a sectional view of another embodiment of this invention. Except that there is no interstitial-via-hole 36 and blind-via-hole 35 of the foregoing embodiments, corresponding components to the foregoing embodiments are given the same reference numerals, and overlapping explanation has been eliminated.

In Figure 12, reference numeral 42 shows lands which are formed in the area of the blind-via-holes 31 of both upper and lower outer substrates 2 and 3, reference numeral 43 shows lands which are formed in the area of the through-holes 32, reference numeral 44 shows the lands which are formed in the area of the layer structured blind-via-hole 33 of the upper outer substrate 2, and reference numeral 45 shows the circuits which are formed in the area of the layer structured blind-via-hole 33 of the lower outer substrate 3. A tip type capacitor 52 is mounted on the land 42 of the upper outer substrate 2. Also, an IC 53 is mounted on the lands 43 and 44 of the upper outer substrate 2. And, on the lands 42, 43 and the land 43 of the lower outer substrate 3, tip type resistor 54 and LSI 55 are mounted, respectively.

According to this invention, a circuit 45 is formed as a part of the total circuit on the multilayer printed circuit board. Also, lands 42, 43 and 44 and circuit 45 are formed by using the plated layer 28 on the conductive paste 22 of blind-via-holes 31, 33 and through-hole 32 (refer to Figure 11). In the conventional multilayer printed circuit board, lands and circuit are not able to be formed on the area of the connection hole. In such an embodiment, lands and circuit can be formed on the area of the connecting hole, so that high density multilayer printed circuit board can be produced. In the above embodiment, reference numeral 46 shows lands formed on both upper and lower outer substrates 2, 3, reference numeral 47 shows circuit, and reference numeral 48 shows solder resist applied on the outer substrates 2, 3.

In the previous embodiment, as to the lamination of the inner substrate after the drilling to the outer substrates 2 and 3, lamination of the inner substrate with the state of copper lamination without drilling can be carried out.

For example, as shown in Figure 7, after the conductive paste 2 is embedded in the connection holes 15, 16 and 17, single-sided copper laminated board (not shown) is laminated onto the inner substrate 1 in which circuit 24 and lands 25 are previously formed. After the proper area on the copper layer of the single-sided copper laminated board is etched, a connection hole which penetrates to the inner substrate is formed by means of physical or chemical processing. Then, the exposed insulation layer by the above etching process is removed. For the removing of the insulation layer, irradiation by laser beam can be also applied. After the conductive paste is embedded in the connection hole, the polishing process and plating process are adopted. Then a multilayer printed circuit board can be produced.

It is further understood by those skilled in the art that the present invention is not limited to the foregoing description of a preferred embodiment and that various changes and modifications may be made in the invention.

For example, the construction of the multilayer printed circuit board with four conductive layers in the foregoing description can be changed to three or two layered multilayer printed circuit board in which two boards are laminated. Moreover, the embodiment of this invention can be adopted for multilayer printed circuit board with more than four boards. In the former example, after the first and the second boards are laminated, the connection hole which penetrates both boards and the connection hole which does not penetrate both boards are formed by means of the foregoing process of the embodiment. After the conductive paste is embedded in the connection hole, polishing of the conductive paste and sealing process by plating are adopted. Thus, a multilayer printed circuit board can be produced.

As mentioned above, the multilayer printed circuit board according to this invention can increase connection reliability because the connection hole in the laminated boards is filled with conductive paste and the conductive paste is sealed by the plated layer. In addition high density multilayer printed circuit board can be produced because land or circuit is formed in the connection area of the multilayer printed circuit board.

## Claims

1. A multilayer printed circuit board comprising: at least two printed circuit boards having a connection hole, said printed circuit boards being laminated with each other, said connection hole being filled with conductive paste, said conductive paste being sealed with a plated layer.

2. A multilayer printed circuit board as claimed in claim 1, wherein the diameter of the connection hole in one of said printed circuit boards is larger than that of the connection hole in the other printed circuit board.

3. A multilayer printed circuit board as claimed in claim 1, wherein said plated layer forms a part of the circuit.

4. A multilayer printed circuit board as claimed in claim 1, wherein said plated layer forms a mounting land for an electronic component.

5. A method of manufacturing a multilayer printed circuit board, said method comprising the steps of:
(a) laminating at least two substrates as the first substrate and the second substrate;
(b) forming a connection hole penetrating both the first substrate and the second substrate and forming a connection hole penetrating not both the first substrate and the second substrate;
(c) filling said connection holes with conductive paste; and
(d) forming a plated layer on said conductive paste.

6. A method of manufacturing a multilayer printed circuit board, said method comprising the steps of:
(a) forming a connection hole in a first substrate;
(b) filling said connection hole with conductive paste;
(c) sealing said conductive paste by a plated layer;
(d) forming a connection hole at least in one substrate forming a second substrate;
(e) laminating said second substrate with said first substrate;
(f) filling said connection hole in said second substrate with conductive paste and filling said connection hole corresponding to both said first substrate and second substrate with conductive paste; and
(g) sealing said conductive paste by a plated layer.

7. A method of manufacturing a multilayer printed circuit board, said method comprising the steps of:
(a) forming a connection hole in a first substrate;
(b) filling said connection hole with conductive paste;
(c) sealing said conductive paste by a plated layer;
(d) laminating at least one substrate forming a second substrate with said first substrate;
(e) forming a connection hole in said second substrate;
(f) filling said connection hole in said second substrate with conductive paste and filling said connection hole corresponding to both said first substrate and second substrate with conductive paste; and
(g) sealing said conductive paste by a plated layer.

8. A method of manufacturing a multilayer printed circuit board as claimed in any one of claims 5, 6 or 7, wherein the diameter of the connection hole in one of said substrates is larger than that of the connection hole in the other substrate.

9. A method of manufacturing a multilayer printed circuit board a claimed in any one of claims 5, 6 or 7, wherein said conductive paste is polished to have the same flat surface to the substrate face as before the plating step.

10. A method of manufacturing a multilayer printed circuit board as claimed in any one of claims 5, 6 or 7, wherein said plated layer forms the circuit.

11. A method of manufacturing a multilayer printed circuit board as claimed in any one of claims 5, 6 or 7, wherein said plated layer forms a mounting land for an electronic component.
